(19) **Europäisches Patentamt / European Patent Office / Office européen des brevets**

(11) **EP 2 015 061 B1**

(12) **FASCICULE DE BREVET EUROPEEN**

(45) Date de publication et mention de la délivrance du brevet:
**26.05.2010 Bulletin 2010/21**

(51) Int Cl.:
**G01N 27/403** (2006.01)

(21) Numéro de dépôt: **08354036.9**

(22) Date de dépôt: **10.06.2008**

(54) **Procédé de détection d'électrodes défectueuses dans une matrice de micro-électrodes**

Verfahren zur Erkennung von defekten Elektroden in einer Mikroelektrodenmatrix

Method of detecting faulty electrodes in an array of micro-electrodes

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **21.06.2007 FR 0704446**

(43) Date de publication de la demande:
**14.01.2009 Bulletin 2009/03**

(73) Titulaire: **Commissariat A L'Energie Atomique - CEA**
**75015 Paris (FR)**

(72) Inventeurs:
• **Chibane, Alexandre**
**F-75013 Paris (FR)**
• **Grangeat, Pierre**
**F-38330 Saint Ismier (FR)**

(74) Mandataire: **Hecké, Gérard et al**
**Cabinet Hecké**
**10, rue d'Arménie**
**Europole**
**BP 1537**
**38025 Grenoble Cedex 1 (FR)**

(56) Documents cités:
**EP-A- 0 774 662      US-A1- 2002 165 675**
**US-B1- 6 428 684      US-B1- 7 208 077**

• **CHIBANE A., GRANGEAT P., DESBAT L., VODA A.: "Application de modèles à dérivée non entière à la détection électrochimique sur biopuce" GRETSI, 2005, XP002474686 Actes du colloque, Louvain la neuve**
• **MYUN JONG JU ET AL: "A new electrochemical sensor for heavy-metal ions by the surface-polarization controlling method" SOLID-STATE SENSORS, ACTUATORS AND MICROSYSTEMS, 2005. DIGEST OF TECHNICAL PAPERS. TRANSDUCERS '05. THE 13TH INTERNATIONAL CONFERENCE ON SEOUL, KOREA JUNE 5-9, 2005, PISCATAWAY, NJ, USA,IEEE, 5 juin 2005 (2005-06-05), pages 1876-1879, XP010829090 ISBN: 0-7803-8994-8**

## Description

### Domaine technique de l'invention

L'invention est relative à un procédé de détection d'électrodes défectueuses dans une matrice d'électrodes comportant une mesure d'impédance de chaque électrode.

### État de la technique

Actuellement, le processus de fabrication des électrodes d'une matrice de micro-électrodes ne permet pas d'obtenir des électrodes parfaitement contrôlées, que ce soit sur le plan de leur géométrie ou en ce qui concerne leur surface. De plus, au fur et à mesure des utilisations, les électrodes se dégradent, notamment avec la formation d'un oxyde de surface et la passivation. De même, des résidus organiques, difficilement retirables par nettoyage, peuvent se former. Il en résulte un contact de plus en plus difficile entre l'électrode et l'électrolyte associé. Ces dégradations influencent les résultats obtenus avec les électrodes. Cela signifie donc que durant leur vie, les électrodes présentent un comportement qui évolue et va en se dégradant. Afin de tester si une électrode est viable, notamment pour la réalisation d'une stimulation neuronale, deux méthodes sont actuellement utilisées.

La première méthode consiste à mesurer le module, en Ohm, de l'impédance de l'électrode à 1 KHz lorsqu'elle est mise en présence d'une solution de chlorure de sodium (NaCl) à une concentration de 0,1 mole par litre, ce qui permet de connaître approximativement le comportement de l'électrode aux fréquences typiques de stimulation. La fréquence typique est une information fournie par le constructeur, et peut être très différente de celle utilisée lors d'une stimulation neuronale. Avec cette méthode, une seule mesure permet de donner une idée de cette impédance.

La seconde méthode utilisée est une mesure du bruit thermique. Cela consiste à mesurer l'amplitude crête à crête de la tension mesurée « à vide » sur l'électrode.

Ces méthodes sont cependant assez simplistes et ne permettent pas de saisir le comportement fin de l'électrode quand elle se dégrade.

Le document US-B-6428684 décrit un procédé permettant de tester des électrodes au moyen de la mesure de spectres d'impédance électrochimique.

### Objet de l'invention

L'objet de l'invention a pour but de remédier à ces inconvénients et, en particulier, de fournir un procédé d'acquisition de données plus fiables et de classification de ces données qui permet d'exclure, de façon plus fine, certaines électrodes dont le comportement serait trop éloigné du comportement standard.

Selon l'invention, ce but est atteint par un procédé de détection d'électrodes défectueuses selon les revendications annexées et plus particulièrement par le fait que le procédé comporte successivement :

- la mesure d'un spectre d'impédance électrochimique pour chacune des électrodes,
- la modélisation, au moyen d'un modèle implicite fréquentiel non entier du spectre d'impédance relatif à chaque électrode, sous forme d'une matrice de paramètres,
- l'analyse en composantes principales de la matrice, qui transforme ladite matrice de paramètres en une matrice finale contenant des variables décorrélées, représentant la matrice de paramètres dans un nouvel espace,
- le calcul de la distance entre chaque électrode et un point de référence,
- la comparaison des distances calculées à une distance seuil prédéterminée et la classification comme défectueuse des électrodes dont la distance est supérieure à la distance seuil.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

- La figure 1 représente, sous forme schématique, un mode de réalisation du procédé selon l'invention.
- La figure 2 représente un schéma électrique utilisé pour l'acquisition des données provenant des électrodes
- La figure 3 représente sous forme graphique la distance de Mahalanobis tronquée, pour deux variables sélectionnées, des électrodes par rapport au centre de l'ellipsoïde (point de référence) avec la représentation de la distance seuil (en abscisse la première variable et en ordonnée la deuxième variable).
- La figure 4, représente sous forme graphique la distance des électrodes au centre de masse de la matrice d'électrodes.

### Description d'un mode préférentiel de l'invention

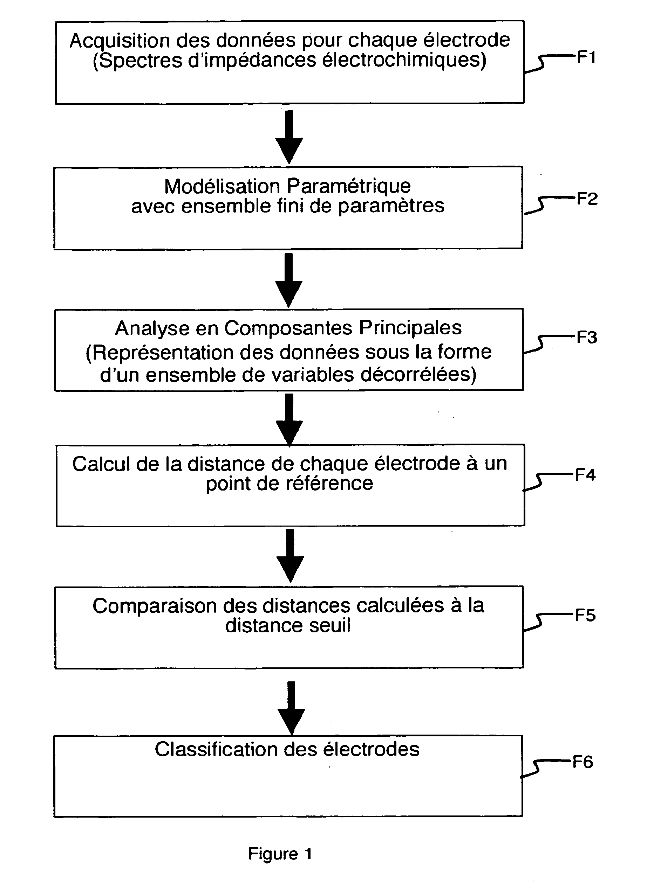

Comme illustré sur la figure 1, l'invention consiste en un enchaînement d'étapes pouvant se décomposer de la manière suivante :

- Acquisition (F1) des données relatives à chaque électrode par acquisition de spectres d'impédance électrochimique,
- Représentation de ces données au moyen d'une modélisation paramétrique avec un ensemble fini de paramètres (F2),

- Réalisation d'une analyse en composantes principales de l'ensemble des paramètres pour représenter les données obtenues dans un nouvel ensemble de variables décorrélées (F3),
- Calcul de la distance d entre chaque électrode et un point de référence (F4),
- Comparaison (F5) de la distance calculée à une distance seuil et classification des électrodes pour déterminer les électrodes défectueuses.

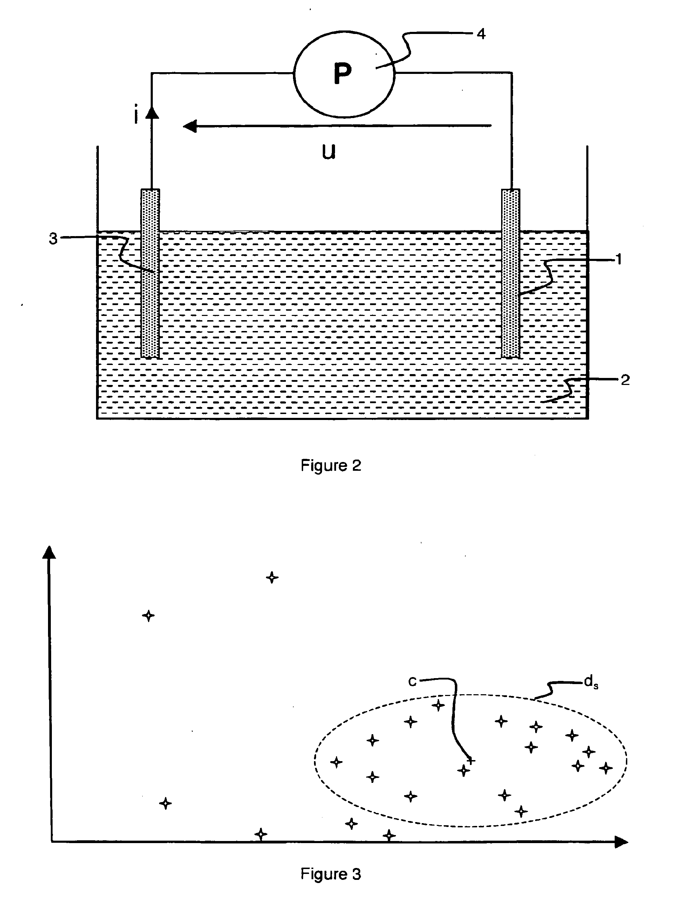

La figure 2 illustre un schéma électrique pouvant être utilisé pour l'acquisition d'un spectre d'impédance électrochimique pour chacune des électrodes de la matrice.

Une électrode 1 à caractériser est plongée dans un électrolyte 2, par exemple une solution contenant un couple oxydo-réducteur connu, de préférence du trichlorure de ruthénium héxamine $Ru(NH_3)_6Cl_3$ (hexamine ruthenium chloride (III) en anglais). Une contre-électrode 3, également plongée dans l'électrolyte 2, est utilisée comme référence. La contre-électrode 3 est de préférence de type Ag/AgCl.

L'électrode 1 à caractériser et la contre-électrode 3 sont connectées à un appareillage de mesure 4, par exemple un potentiostat, qui applique une tension sinusoïdale u(t) de faible amplitude et de fréquence pure autour du potentiel d'oxydoréduction standard Eo du couple oxydo-réducteur utilisé. La tension sinusoïdale appliquée est de la forme u(t) = $E_0$ + $V_0$cos($\omega t$), dans laquelle Vo est une amplitude prédéterminée. L'appareillage de mesure 4 acquiert, dans le même temps, l'intensité $i(t)$ du courant parcourant l'électrode 1 à caractériser. Cette intensité $i(t)$ est assimilée à une sinusoïde pure de la forme $i(t)$ = $I$cos($\omega t$ + $\phi$).

On peut alors déduire, de la tension sinusoïdale u(t) et de l'intensité $i(t)$ également sinusoïdale, une impédance associée à chaque électrode. On répète ces opérations pour chaque fréquence du spectre d'impédance et pour chaque électrode de la matrice. Les fréquences d'échantillonnage utilisées pour réaliser le spectre d'impédance sont classiquement dans la gamme 100Hz - 10kHz. De plus, pour réaliser un spectre d'impédance, de préférence, au moins 10 fréquences sont utilisées, avantageusement 20 fréquences sont choisies.

Pour une électrode 1 j de la matrice d'électrodes, un spectre d'impédance de la cellule électrochimique complète est ainsi obtenu pour une pluralité de fréquences. L'identification paramétrique d'un modèle implicite fréquentiel non entier pour ledit spectre d'impédance est réalisée. Ce modèle paramétrique est avantageusement obtenu avec la méthode décrite dans l'article de Chibane et Al. (« Application de modèles à dérivée non entière à la détection électrochimique sur biopuce », actes du colloque GRETSI 2005, 06-09/09/2005 Louvain La Neuve Belgique). Ce modèle rend compte du comportement fréquentiel de l'électrode associée et est représenté, par exemple, sous la forme :

$$Z(\omega) = Z_0 \frac{1}{(i\omega)^{n_0}} \prod_{p=1}^{N}(1 + \frac{i\omega}{\omega_p})^{n_p}$$

où $n_p$ et $\omega_p$ représentent l'ordre du monôme et sa fréquence de coupure.

Ce modèle paramétrique du spectre d'impédance de l'électrode 1 à caractériser est représenté par un vecteur **A** de n dimensions, avec n = 2N +2, qui représente le comportement fréquentiel de la cellule électrochimique comportant l'électrode 1 à caractériser. A titre d'exemple, la vecteur peut être mis sous la forme

$$\mathbf{A} = \begin{pmatrix} Z_0 \\ n_0 \\ \omega_1 \\ n_1 \\ ... \\ \omega_p \\ n_p \end{pmatrix},$$

Ce vecteur **A** est noté schématiquement, pour l'électrode 1 j :

$$\mathbf{A} = \begin{pmatrix} x_1(e_j) \\ x_2(e_j) \\ ... \\ x_n(e_j) \end{pmatrix},$$

où $x_q(e_j)$ représente le q-ème paramètre identifié pour l'électrode 1 j, avec q = 1 à n.

Une fois l'acquisition des spectres d'impédance effectuée pour toutes les électrodes, chaque cellule électrochimique est représentée alors par un vecteur **A** de n dimensions du type mentionné ci-dessus. Cet ensemble de vecteurs est alors regroupé en une matrice **B** qui représente l'ensemble des k électrodes. La matrice **B** se représente sous la forme :

$$\mathbf{B} = \begin{pmatrix} x_1(e_1) & x_2(e_1) & ... & ... & x_n(e_1) \\ x_1(e_2) & x_2(e_2) & ... & ... & x_n(e_2) \\ ... & ... & ... & ... & ... \\ x_1(e_k) & x_2(e_k) & ... & ... & x_n(e_k) \end{pmatrix}$$

où chaque ligne représente les paramètres associés à une électrode 1 j et chaque colonne représente, pour l'ensemble des électrodes, les paramètres $x_q(e_j)$, avec q =1 à n, correspondant à la même mesure fréquentielle.

L'analyse en composantes principales est utilisée pour réduire le nombre de paramètres et extraire ainsi le maximum d'information. Cette analyse comporte la normalisation et la réduction de chaque paramètre $x_q(e_j)$ par rapport à l'ensemble des paramètres $x_q$.

La nouvelle variable $x'_q(e_j)$ ainsi obtenue est caractérisée par la relation :

$$x'_q(e_j) = \frac{\left(x_q(e_j) - \hat{x}_q\right)}{\sigma\left(x_q\right)}$$

où $\hat{x}_q$ et $\sigma(x_q)$ représentent respectivement la moyenne et l'écart-type des paramètres $x_q$ sur l'ensemble des k électrodes composant la matrice d'électrodes. Ces deux opérations permettent de transformer la matrice B en une matrice **X** représentée sous la forme

$$\mathbf{X} = \begin{pmatrix} x'_1(e_1) & x'_2(e_1) & \dots & \dots & x'_n(e_1) \\ x'_1(e_2) & x'_2(e_2) & \dots & \dots & x'_n(e_2) \\ \dots & \dots & \dots & \dots & \dots \\ x'_1(e_k) & x'_2(e_k) & \dots & \dots & x'_n(e_k) \end{pmatrix}$$

Une matrice **M** de covariance est, ensuite, obtenue à partir de la matrice **X** par la relation :

$$\mathbf{M} = \frac{1}{n-1}\mathbf{X^T X}$$ où $\mathbf{X^T}$ est la transposée de la matrice **X.** La matrice **M** est une matrice carrée et symétrique. La dimension de la matrice **M** est (n x n) si n<k et (k x k) dans le cas contraire.

La matrice **M** est diagonalisée et les valeurs propres obtenues sont classées par ordre décroissant afin de former une matrice **D**. Les plus grandes valeurs propres obtenues correspondent aux axes principaux d'inertie dans un nouvel espace de représentation. Une matrice **V** est alors obtenue à partir des matrices **M** et **D** par la relation : **V^T DV = M.**

Une matrice **Y** est ,ensuite, obtenue par la formule : **Y=XV.** Ainsi, la matrice **Y** constitue une représentation des variables de la matrice **X,** pour chaque électrode à caractériser, dans un nouvel espace de représentation, où les nouvelles variables sont alors décorrélées. La matrice **Y** est représentée par un ensemble de variables $y_q(e_j)$ correspondant au q-ème paramètre de la j-ème électrode.

A partir de cette matrice **Y,** il est possible de calculer la distance d entre l'électrode 1 j et un point de référence et de la comparer à une distance seuil préalablement définie. La distance de Mahalanobis $d_M$ est préférentiellement utilisée. Une représentation sous forme graphique de l'ensemble des électrodes à un point de référence peut être utilisée pour faire la comparaison. Avantageusement, le point de référence peut être la représentation de la moyenne sur l'ensemble des électrodes.

Dans le mode de réalisation particulier, la figure 3 est une représentation sous forme graphique de la distance de Mahalanobis tronquée de chaque électrode au point de référence sur les deux variables les plus explicatives. La distance seuil $d_s$ au point de référence c a une forme ellipsoïdale dans la représentation choisie et le point de référence c est caractérisé par le centre de l'ellipsoïde. La représentation sous forme graphique autorise une discrimination aisée et rapide des électrodes défectueuses, qui correspondent aux points situés à l'extérieur de l'ellipse correspondant à la distance seuil $d_s$. La valeur du seuil peut être prédéterminée ou définie au moyen de tests statistiques.

Dans une variante de réalisation, une pluralité de valeurs propres, correspondant aux plus grandes valeurs propres calculées, sont sélectionnées. Ceci permet la sélection d'une pluralité de variables associées pour chaque électrode, réduisant la dimensionnalité de la matrice finale et autorisant alors l'analyse séparée de chaque composante pour chaque électrode. Dans ce cas, chaque électrode à alors autant de composantes que de valeurs propres sélectionnées. En réduisant le nombre de valeurs propres, la quantité de données à traiter est également réduite. Avantageusement, le choix du nombre de valeurs propres à étudier est défini en fonction de la marge d'erreur qui est autorisée pour le résultat.

Dans un cas particulier où les valeurs propres choisies et, donc, les composantes associées sont, par exemple, au nombre de trois, la distribution de valeurs des variables est considérée comme gaussienne séparable sur chaque composante. Le point de référence utilisé pour calculer la distance à l'électrode est défini par la gaussienne sur chaque composante. Pour chaque composante, la distance de l'électrode au point de référence se traduit alors, de préférence, par le calcul de la distance de normalité à la gaussienne associée. Cette dernière distance est calculée de la manière suivante :

$$d = \frac{\left|y_q(e_j) - m_q\right|}{\sigma_q}$$

où $m_q$ et $\sigma_q$ représentent la moyenne et l'écart-type de la variable $y_q(e_j)$ calculées sur toutes les électrodes.

Cependant, il est également possible d'obtenir une distribution de valeurs considérées comme gaussienne séparable sur chaque composante dans le cas où plus de 3 variables ont été sélectionnées.

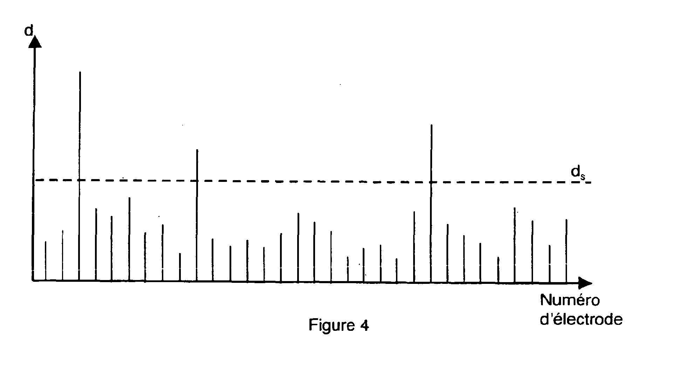

Pour chaque électrode 1 à caractériser, l'addition des distances calculées sur chacune de ces composantes permet l'obtention de la distance d au point de référence. Dans ce cas particulier, comme illustré sur la figure 4, la représentation sous forme graphique peut se traduire simplement par la distance d de chaque électrode au point de référence en fonction du numéro de l'électrode (de 1 à n). Si la distance d d'une électrode est supérieure à la distance seuil $d_s$ l'électrode est alors considérée comme défectueuse.

## Revendications

1. Procédé de détection d'électrodes défectueuses dans une matrice d'électrodes comportant une mesure d'impédance de chaque électrode, **caractérisé en ce qu'**il comporte successivement :

   - la mesure d'un spectre d'impédance électrochimique pour chacune des électrodes (1),
   - la modélisation, au moyen d'un modèle implicite fréquentiel non entier du spectre d'impédance relatif à chaque électrode, sous forme d'une matrice de paramètres **(A),**
   - l'analyse en composantes principales de la matrice **(X),** qui transforme ladite matrice de paramètres en une matrice finale **(Y)** contenant des variables ($y_q(e_j)$) décorrélées, représentant la matrice de paramètres dans un nouvel espace,
   - le calcul de la distance (d) entre chaque électrode et un point de référence (c),
   - la comparaison des distances (d) calculées à une distance seuil ($d_s$) prédéterminée et la classification comme défectueuse des électrodes dont la distance est supérieure à la distance seuil.

2. Procédé selon la revendication 1, **caractérisé en ce que** la distance entre deux électrodes est calculée à l'aide de la distance de Mahalanobis ($d_M$).

3. Procédé selon l'une des revendications 1 et 2, **caractérisé en ce que** la mesure d'impédance est réalisée dans une solution contenant la matrice d'électrodes (1), une contre-électrode (3) et un électrolyte (2).

4. Procédé selon la revendication 3, **caractérisé en ce que** l'électrolyte (2) est un couple oxydo-réducteur.

5. Procédé selon l'une des revendications 3 et 4, **caractérisé en ce que** l'électrolyte (2) est en trichlorure de ruthénium héxamine.

6. Procédé selon l'une quelconque des revendications 3 à 5, **caractérisé en ce que** la contre-électrode (3) est de type Ag/AgCl.

7. Procédé selon l'une quelconque des revendications 3 à 6, **caractérisé en ce que** la mesure d'impédance d'une électrode à caractériser (1) est réalisée par application d'une tension sinusoïdale ($u(t)$) entre ladite électrode (1) et la contre-électrode (3), à une pluralité de fréquences.

8. Procédé selon l'une quelconque des revendications 1 à 7, **caractérisé en ce que** l'analyse en composantes principales comporte :

   - la transformation de la matrice de paramètres **(B)** en une matrice intermédiaire **(M),** constituée d'une pluralité de variables, la matrice intermédiaire étant carrée et diagonalisable,
   - la détermination des valeurs propres associées à la matrice intermédiaire,
   - le calcul de la matrice finale **(Y),** représentative de la matrice **(B)** de paramètres dans un nouvel espace défini par les valeurs propres associées à la matrice intermédiaire.

9. Procédé selon la revendication 8, **caractérisé en ce qu'**une sélection est réalisée sur quelques valeurs propres de la matrice intermédiaire **(M),** représentant les plus grandes valeurs propres, entraînant la sélection de quelques variables au sein de la matrice finale **(Y)** associées aux dites valeurs propres.

10. Procédé selon les revendications 8 ou 9, **caractérisé en ce que** la distribution des variables $y_q(e_j)$ est considérée comme gaussienne et séparable sur chaque composante.

11. Procédé selon la revendication 10, **caractérisé en ce que** le point de référence c est le centre de masse de la matrice d'électrode et que la distance de l'électrode au point de référence correspond à la distance de normalité à la gaussienne associée.

12. Procédé selon l'une quelconque des revendications 1 à 11, **caractérisé en ce que** la distance d et la distance de seuil $d_s$ sont représentées sous forme graphique pour réaliser la comparaison.

## Claims

1. A method for detecting defective electrodes in an electrode matrix comprising impedance measurement of each electrode, **characterized in that** it comprises:

   - measuring an electrochemical impedance spectrum for each of the electrodes (1),

- modeling of the impedance spectrum relative to each electrode by means of an implicit non-integral frequency model, in the form of a parameter matrix (A),
- performing principal components analysis of the matrix (X), which transforms said parameter matrix into a final matrix (Y) containing decorrelated variables ($y_q(e_j)$) representing the parameter matrix in a new space,
- calculating the distance (d) between each electrode and a reference point (c),
- comparing the calculated distances (d) with a preset threshold distance, and classifying the electrodes having a distance greater than the threshold distance ($d_s$) as being defective.

2. The method according to claim 1, **characterized in that** the distance between two electrodes is calculated by means of the Mahalanobis distance ($d_M$).

3. The method according to one of claims 1 and 2, **characterized in that** the impedance measurement is performed in a solution containing the electrode matrix (1), a counter-electrode (3) and an electrolyte (2).

4. The method according to claim 3, **characterized in that** the electrolyte (2) is an oxidation-reducing couple.

5. The method according to one of claims 3 and 4, **characterized in that** the electrolyte (2) is made of hexamine ruthenium chloride (III).

6. The method according to anyone of the claims 3 to 5, **characterized in that** the counter-electrode (3) is of Ag/AgCl type.

7. The method according to anyone of the claims 3 to 6, **characterized in that** the impedance measurement of an electrode to be characterized (1) is performed by applying a sine-wave voltage ($u(t)$) between said electrode (1) and the counter-electrode (3) at a plurality of frequencies.

8. The method according to anyone of the claims. 1 to 7, **characterized in that** the principal components analysis comprises:

- transforming the parameter matrix into an intermediate matrix (B) constituted by a plurality of variables, the intermediate matrix (M) being square and diagonalizable,
- determining the eigenvalues associated with the intermediate matrix,
- calculating the final matrix (Y) representative of the parameter matrix (B) of in a new space defined by the eigenvalues associated with the intermediate matrix.

9. The method according to claim 8, **characterized in that** a selection is made on some eigenvalues of the intermediate matrix (M) representing the largest eigenvalues, leading to selection of some variables in the final matrix (Y) associated with said eigenvalues.

10. The method according to one of the claims 8 and 9, **characterized in that** the distribution of variables $y_q(e_j)$ is considered as being gaussian and separable on each component.

11. The method according to claim 10, **characterized in that** the reference point (c) is the mass center of the electrode matrix and the distance from the electrode to the reference point corresponds to the distance of normality at the associated gaussian.

12. The method according to anyone of the claims 1 to 11, **characterized in that** the distance (d) between the electrode and the reference point and the threshold distance ($d_s$) are represented in graphic form to make the comparison.

**Patentansprüche**

1. Verfahren zum Erfassen von fehlerhaften Elektroden in einer Matrix von Elektroden mit einer Impedanzmessung jeder Elektrode, **dadurch gekennzeichnet, dass** es nacheinander umfasst:

- die Messung eines elektrochemischen Impedanzspektrums für jede der Elektroden (1),
- die Modellierung eines impliziten, nicht ganzzahligen Frequenzmodells des Impedanzspektrums relativ zu jeder Elektrode in Form einer Matrix von Parametern (A),
- die Hauptkomponentenanalyse der Matrix (X), welche die Matrix von Parametern in eine dekorrelierte Variablen ($y_q(e_j)$) enthaltende endgültige Matrix (Y) transformiert, welche die Matrix von Parametern in einem neuen Raum darstellt,
- die Berechnung der Distanz (d) zwischen jeder Elektrode und einem Bezugspunkt (c),
- den Vergleich der berechneten Distanzen (d) mit einer vorbestimmten Schwellendistanz ($d_s$) und die Klassifizierung der Elektroden als fehlerhaft, deren Distanz über der Schwellendistanz liegt.

2. Verfahren nach Anspruch 1, **dadurch gekennzeichnet, dass** die Distanz zwischen zwei Elektroden mit Hilfe der Mahalanobis-Distanz ($d_M$) berechnet wird.

3. Verfahren nach einem der Ansprüche 1 und 2, **dadurch gekennzeichnet, dass** die Impedanzmessung in einer Lösung durchgeführt wird, welche die Matrix von Elektroden (1), eine Gegenelektrode (3) und einen Elektrolyten (2) enthält.

4. Verfahren nach Anspruch 3, **dadurch gekennzeichnet, dass** der Elektrolyt (2) ein Oxidreduktormoment ist.

5. Verfahren nach einem der Ansprüche 3 und 4, **dadurch gekennzeichnet, dass** der Elektrolyt (2) aus Ruthenium-Hexamin-Trichlorid besteht.

6. Verfahren nach einem der Ansprüche 3 bis 5, **dadurch gekennzeichnet, dass** die Gegenelektrode (3) vom Typ Ag/AgCl ist.

7. Verfahren nach einem der Ansprüche 3 bis 6, **dadurch gekennzeichnet, dass** die Impedanzmessung einer zu charakterisierenden Elektrode (1) durch Anlegen einer sinusförmigen Spannung (u(t)) zwischen der Elektrode (1) und der Gegenelektrode (3) bei einer Vielzahl von Frequenzen durchgeführt wird.

8. Verfahren nach einem der Ansprüche 1 bis 7, **dadurch gekennzeichnet, dass** die Hauptkomponentenanalyse umfasst:

   - die Transformation der Matrix von Parametern (B) in eine Zwischenmatrix (M), die aus einer Vielzahl von Variablen gebildet ist, wobei die Zwischenmatrix quadratisch und diagonalisierbar ist,
   - die Bestimmung der Eigenwerte, die der Zwischenmatrix zugeordnet sind,
   - die Berechnung der endgültigen Matrix (Y), welche für die Matrix (B) von Parametern in einem neuen Raum steht, der durch die der Zwischenmatrix zugeordneten Eigenwerte definiert ist.

9. Verfahren nach Anspruch 8, **dadurch gekennzeichnet, dass** eine Auswahl an einigen Eigenwerten der Zwischenmatrix (M) durchgeführt wird, welche die größten Eigenwerte darstellen, was die Auswahl von einigen Variablen innerhalb der endgültigen Matrix (Y) mit sich bringt, die den Eigenwerten zugeordnet sind.

10. Verfahren nach den Ansprüchen 8 oder 9, **dadurch gekennzeichnet, dass** die Verteilung der Variablen $y_q(e_j)$ als gaussisch und an jeder Komponente trennbar gilt.

11. Verfahren nach Anspruch 10, **dadurch gekennzeichnet, dass** der Bezugspunkt c das Massenzentrum der Elektrodenmatrix ist und dass die Distanz der Elektrode zum Bezugspunkt der Normalitätsdistanz zur zugeordneten Gaussischen entspricht.

12. Verfahren nach einem der Ansprüche 1 bis 11, **dadurch gekennzeichnet, dass** die Distanz d und die Schwellendistanz $d_s$ in graphischer Form dargestellt werden, um den Vergleich durchzuführen.

| Acquisition des données pour chaque électrode (Spectres d'impédances électrochimiques) | F1 |

| Modélisation Paramétrique avec ensemble fini de paramètres | F2 |

| Analyse en Composantes Principales (Représentation des données sous la forme d'un ensemble de variables décorrélées) | F3 |

| Calcul de la distance de chaque électrode à un point de référence | F4 |

| Comparaison des distances calculées à la distance seuil | F5 |

| Classification des électrodes | F6 |

Figure 1

Figure 2

Figure 3

Figure 4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6428684 B


**Littérature non-brevet citée dans la description**

- **CHIBANE et al.** Application de modèles à dérivée non entière à la détection électrochimique sur biopuce. *actes du colloque GRETSI 2005,* 06 Septembre 2005